# EUROPÄISCHE PATENTSCHRIFT

(11) **EP 0 547 419 B1**
(45) Veröffentlichungstag und Bekanntmachung des Hinweises auf die Patenterteilung: **04.02.1998**
(21) Anmeldenummer: 92120404.6
(22) Anmeldetag: 30.11.1992
(51) Int. Cl.: G03F 7/039, G03F 7/20

(54) **Verfahren zur Herstellung von Mikrostrukturkörpern**
Process for making microstructures
Procédé de fabrication de microstructures

(30) Priorität: 14.12.1991 DE 4141352
(43) Veröffentlichungstag der Anmeldung: 23.06.1993
(73) Patentinhaber: BASF Aktiengesellschaft, 67063 Ludwigshafen (DE)
(72) Erfinder: Hoessel, Peter, Dr., W-6707 Schifferstadt (DE); Hoffmann, Gerhard, Dr., W-6701 Otterstadt (DE); Langen, Juergen, Dr., W-5300 Bonn 3 (DE); Reinecke, Holger, Dr., W-6729 Ruelzheim (DE)

(56) Entgegenhaltungen:
- EP-A- 0 264 926
- EP-A- 0 314 245
- MICROELECTRONIC ENGINEERING. Bd. 4, Nr. 1, Mai 1981, AMSTERDAM NL Seiten 35 - 56 BECKER E.W. ET AL 'Fabrication of microstructures with high aspect ratios and great structural heights by synchrotron radiation lithography, galvanoforming, and plastic moulding (LIGA process)'

## Beschreibung

Die Erfindung betrifft ein Verfahren zur Herstellung von Mikrostrukturkörpern mit Strukturtiefen von mehreren µm bis in den mm-Bereich bei Lateralabmessungen im Mikrometerbereich durch Bestrahlen von Polymeren mit Röntgenstrahlen und nachfolgender Entwicklung mit geeigneten Entwicklermedien.

Die Entwicklung der Mikroelektronik hat gezeigt, daß die konsequente Miniaturisierung und Integration zu einer unüberschaubaren Vielfalt neuer Produkte mit entsprechenden Technologien führt. Die Mikroelektronik hat in wenigen Jahren gegenüber anderen Industriezweigen einen gewaltigen Vorsprung in der Miniaturisierung gewonnen. Inzwischen zeichnet sich ab, daß in Zukunft auch andere Mikrotechniken eine große Bedeutung erlangen werden, wobei insbesondere die Mikromechanik und die integrierte Optik zu erwähnen sind. Solche Techniken eröffnen in der Kombination mit der Mikroelektronik eine unvorstellbare Zahl neuer elektronischer, optischer, biologischer und mechanischer Funktionselemente.

Bei einer Massenfertigung von nichtelektronischen Bauelementen, Systemkomponenten und Subsystemen der Mikrotechnik wird man naturgemäß die außerordentlich leistungsfähigen Fertigungsmethoden der Halbleitertechnik in möglichst großem Umfang nutzen. Gleichzeitig muß man versuchen, klassische Methoden der Feinwerktechnik für die Mikromechanik zu ertüchtigen und mit entsprechend modifizierten Halbleiterfertigungsmethoden zu verschmelzen, um so die engen Grenzen der Siliciumplanartechnik verlassen und neue Gestaltungsmöglichkeiten erschließen zu können, die auf einer Vielfalt von Formen und Materialien aufbauen. Diese Forderung wird z.B. in hohem Maße durch das LIGA-Verfahren erfüllt, das auf den Fertigungsschritten
- Lithographie,
- Galvanoformung und
- Abformung
aufgebaut und am Kernforschungszentrum Karlsruhe (KfK) entwickelt worden ist.

Interessante Mikrostrukturprodukte sind Sensoren zur Messung von Beschleunigung, Durchfluß, Ultraschall, Feuchte u.ä., Mikromotoren, mikropneumatische Bauelemente, Mikrostecker für die Mikroelektronik, mikrooptische Bauelemente, Faseroptiken, Mikroelektroden, Spinndüsen, Mikrofilter, Gleitlager, Membrane und vieles andere mehr.

Der wesentliche Fertigungsschritt des LIGA-Verfahrens ist die strukturgenaue Bestrahlung des eingesetzten Polymeren. Die prinzipielle Durchführbarkeit des LIGA-Verfahrens konnte anhand einfacher Mikrostrukturen mit einem speziell hergestellten Polymethylmethacrylat (im folgenden PMMA genannt) nachgewiesen werden.

Bei der Herstellung komplexer dreidimensionaler Strukturen mit Strukturtiefen von mehreren µm bis in den mm-Bereich nach dem oben genannten LIGA-Verfahren hat sich gezeigt, daß PMMA einen hohen Bestrahlungsaufwand erfordert.

Weiter hat sich gezeigt, daß bei der Entwicklung der bestrahlten Polymeranteile mit einem geeigneten Entwicklermedium die unbestrahlten Polymeranteile quellen, wobei feine Mikrostrukturen zerstört werden können. Andererseits können gequollene Polymeranteile beim Austrocknen zu Spannungsrissen führen, die bei der Galvanik zu unbrauchbaren Mikrostrukturkörpern führen. Ursache für diese Probleme ist die hohe Lösungsmittelempfindlichkeit des PMMA.

Aufgabe der Erfindung war es, ein Polymer zu finden, welches einen geringeren Bestrahlungsaufwand bei Bestrahlung mit Synchrotronstrahlung erfordert, unter dem Einfluß von Röntgenlicht depolymerisiert und mit speziellen Entwicklern selektiv entfernbar ist; das Polymere sollte ferner eine einfache Probekörperherstellung, beispielsweise durch Spritzguß, Pressen, Extrusion bzw. Gießen ermöglichen und keine Quellung, keine Spannungsrisse und keine Fehlstellen aufweisen.

Außerdem sollte das Polymer mikrostrukturierbar sein, d.h. das Polymer sollte auch als Mikrostruktur unter 5 bis 10 µm bei gleichzeitig hohem Aspektverhältnis (= Strukturhöhe : Strukturbreite) von 5:1 bis 1000:1, vorzugsweise zwischen 20:1 bis 50:1, ausreichende thermomechanische Festigkeit besitzen. Damit Galvanikprozesse problemlos überstanden werden, sollte das Polymer bis 60°C mechanisch stabil und gleichzeitig beständig gegen z.B. Schwefelsäure und Amidoschwefelsäure sein.

Überraschenderweise wurde gefunden, daß aliphatische Polyester, insbesondere Polyglycolid- und Polylactidhomo- und -copolymere sowie Homo- und Copolymere der 3- und 4-Hydroxybuttersäure diese Forderungen erfüllen.

Die Verwendbarkeit von Polyglycolid- und Polylactidhomo- und -copolymeren zur Herstellung von Mikrostrukturkörpern, bei der es auf ein hohes Aspektverhältnis ankommt, wie dies beispielsweise für das LIGA-Verfahren erforderlich ist, und die sich dabei ergebenden Vorteile waren überraschend und konnten aus den bisher bekannten Druckschriften nicht hergeleitet werden.

Gegenstand der vorliegenden Erfindung ist ein Verfahren zur Herstellung von Mikrostrukturkörpern mit Strukturtiefen von mehreren µm bis in den mm-Bereich durch bildmäßiges Bestrahlen von Polymeren mit Röntgenstrahlen, das dadurch gekennzeichnet ist, daß als Polymere aliphatische Polyester eingesetzt werden.

Hierfür bevorzugte aliphatische Polyester sind Polyglycolid, Polylactid oder Glycolid-/Lactidcopolymere.

Als Röntgenstrahlung kann vorzugsweise Synchrotronstrahlung eingesetzt werden.

Zur Durchführung des erfindungsgemäßen Verfahrens können die aliphatischen Polyester durch Spritzguß, Extrusion und/oder Pressen auf einen Träger aufgebracht werden.

Nach dem erfindungsgemäßen Verfahren lassen sich Mikrostrukturkörper mit Strukturtiefen zwischen 3 µm und 2000 µm herstellen, so daß durch Bestrahlung mit Synchrotronstrahlung und Einwirkung selektiver Entwickler in einer Abtragstiefe von 10 µm bis 2000 µm bei lateralen Abmessungen von unter 10 µm strukturiert werden kann.

Als selektive Entwickler eignen sich vorzugsweise z.B. wäßrige oder alkoholische Natriumhydroxidlösungen oder Amin enthaltende Entwicklerlösungen.

Die Bestrahlung erfolgt beim erfindungsgemäßen Verfahren mittels energiereicher paralleler Strahlung aus Röntgenstrahlquellen. Die Wellenlängen dieser Strahlen liegen in einem Bereich von 0,1 bis 10 nm, vorzugsweise 0,1 bis 1,0 nm.

Derartige Bestrahlungen können beispielsweise an einem Synchrotron mit speziellen Vorabsorbern, z.B. aus Beryllium oder Polyimidfolie (z.B. Kapton® der Fa. Du Pont de Nemours) mit Bestrahlungszeiten von 1 min bis 300 min bei einem mittleren Ringstrom von 25 mA durchgeführt werden.

Der Bestrahlungsaufwand ist abhängig von der Elektronenenergie im Elektronenspeicherring, der vom Synchrotron abgezweigt ist. Im allgemeinen beträgt die Elektronenenergie 1,6 bis 2,3 GeV.

Zur bildmäßigen Bestrahlung werden üblicherweise spezielle Röntgenmasken, beispielsweise aus einer Titanträgerfolie mit Goldabsorberstrukturen verwendet.

Als Polymere werden erfindungsgemäß aliphatische Polyester, insbesondere Polyglycolid- und Polylactidhomo- und -copolymere eingesetzt.

Polyglycolid- und Polylactidhomo- und -copolymere sind bekannt und beispielsweise in US-A-4,744,365; EP-A 314 245; JP 122643 (= J6 0014-861-A); EP-A 264 926; G. Rafler, L. Dahlmann, I. Ruhnau, Acta Polymerica 41 (1990) 628; Ph. Dubois, C. Jacobs, R. Jérôme, Ph. Teyssié, Macromolecules 24 (1991) 2266; R. Rafler, J. Dahlmann, Acta Polymerica 41 (1990) 611, sowie in T. Masuda, A. Matsuda, S. Yamazaki, I. Takahashi, K. Sato, Polymer Preprints, Japan 39 (1990) 5 beschrieben.

Für das erfindungsgemäße Verfahren besonders geeignet sind Polyglycolide, D,L-Polylactid, D- und L-Polylactid und Copolymere, d.h. Poly(glycolid-co-D,L-lactid), Poly(glycolid-co-D-lactid), Poly(glycolid-co-L-lactid) und Poly-(L-lactid-co-D,L-lactid)e und Poly-(D-lactid-co-D,L-lactid)e.

Außerdem sind Copolymere mit bis zu 50 % ε-Caprolacton und/oder Trimethylencarbonat als Aufbaukomponente geeignet, z.B. Poly-(L-lactid-co-ε-caprolacton), Poly-(L-lactid-co-trimethylencarbonat), Poly(glycolid-co-ε-caprolacton) und Poly(glycolid-co-trimethylencarbonat). Geeignet sind auch 3- und 4-Hydroxybuttersäurehomo- und -copolymere, beispielsweise Copolymere der 3- und 4-Hydroxybuttersäure mit Hydroxyvaleriansäuren (Mengenverhältnis der Comonomeren zueinander 100:5 bis 100:50, vorzugsweise 9:1 bis 7:3), beispielsweise Biopol®-Polymere der Fa. ICI.

In der Regel haben die verwendeten aliphatischen Polyester ein mittleres Molekulargewicht von 10.000 bis 1.000.000, vorzugsweise 200.000 bis 300.000 bzw. inhärente Viskositäten zwischen 2,5 und 9, vorzugsweise zwischen 7 und 9 dl/g.

Bevorzugt sind für das erfindungsgemäpe Verfahren teilkristalline Derivate mit Schmelzpunkten zwischen 140 und 230°C, z.B. Polyglycolid, L- bzw. D-Polylactid und Copolymere wie Poly(glycolid-co-L,D-lactid) und Poly-(L-lactid-co-D,L-lactid).

Beispiele für derartige besonders bevorzugte aliphatische Polyester sind Poly-L-lactid (z.B. Resomer® L 214 der Fa. Boehringer, Ingelheim) und Poly-L-lactid(90)-co-D,L-lactid(10) (z.B. Resomer LR 909).

Die Herstellung geeigneter aliphatischer Polyester kann vorzugsweise durch ringöffnende Polymerisation von 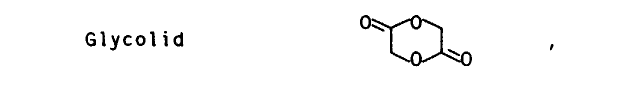 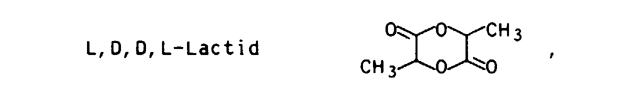 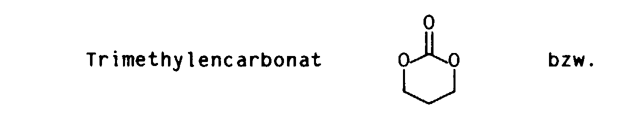 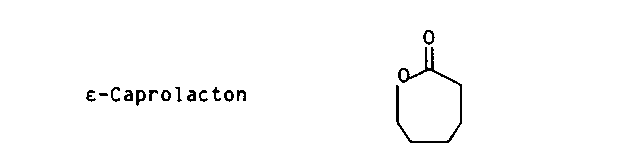 durchgeführt werden (vgl. R. Rafler, J. Dahlmann, Acta Polymerica 41 (1990) 611).

Polyglycolid kann jedoch auch aus Kohlenmonoxid und Formaldehyd dargestellt werden (vgl. T. Masuda, Polymer Preprints, Japan 39 (1990) 5).

Wie bereits oben erwähnt, können zur Herstellung von Mikrostrukturkörpern die aliphatischen Polyester, insbesondere Polyglycolid- und Polylactidhomo- und -copolymere als Granulat oder in Pulverform nach üblichen Verfahren, wie z.B. durch Pressen, Spritzguß und/oder Extrusion bei Temperaturen zwischen 20 und 240°C auf elektrisch leitende Metallträger, wie z.B. aus Nickel, Kupfer oder Stahl, auf die gegebenenfalls eine 0,1 bis 50 µm dicke Schicht aus einem weiteren Metall oder Metalloxid, z.B. Titan, aufgebracht wurde, gegebenenfalls unter Mitverwendung spezieller Haftlacke oder spezieller Haftvermittler aufgebracht und fixiert werden. Die Schichtdicke der Homo- und Copolymeren auf dem Metallträger liegt im allgemeinen zwischen 20 und 2000, vorzugsweise 50 bis 800, insbesondere zwischen 100 und 500 µm. Die Oberfläche der Homo- oder Copolymerschichten sollte zweckmäßigerweise möglichst glatt sein.

Nach dem bildmäßigen Bestrahlen wird mit geeigneten Entwicklermedien entwickelt.

Als Entwickler können basische Entwickler, z.B. 0,1 bis 20 %ige Natriumhydroxidlösung in Wasser oder in Wasser/Isopropanolgemischen eingesetzt werden. Es erfolgt kein Angriff auf unbestrahlte Bereiche.

Auch organische Säuren - Ameisensäure, Essigsäure - oder aminische Entwickler zeigen Abträge, die jedoch unterhalb denen liegen, welche mit Natriumhydroxidlösungen erzielt werden.

Die so erhaltenen Mikrostrukturen zeigen im Vergleich zu GG-Entwickler, wie in DE-C-30 39 110 für PMMA beschrieben, bei gleichem Bestrahlungsaufwand erheblich größere Strukturtiefen. Es ließen sich so Strukturen mit lateralen Abmessungen unter 10 µm bei maximaler Strukturhöhe von mehreren hundert µm herstellen, die keine Defekte aufwiesen.

Die so erhaltenen Mikrostrukturen zeigen scharfe, steile Kanten und glatte Wände und sind beständig gegenüber den im LIGA-Prozeß verwendeten Galvanikbädern, d.h. z.B. sauren Kupfer- bzw. Nickelgalvanikbädern. Bei Temperaturen zwischen 20 und 60°C bleiben die Mikrostrukturen über 24 Stunden in den Galvanikbädern unverändert.

Der neben der Abtragstiefe gröpte Vorteil der erfindungsgemäß eingesetzten aliphatischen Polyester im Vergleich zu PMMA als Resist für den LIGA-Prozeß ist deren hervorragende Spannungsrißbeständigkeit in den Mikrostrukturen.

Die in den folgenden Beispielen genannten Teile und Prozente sind, soweit nicht anders angegeben, Gewichtsteile bzw. Gewichtsprozente.

### Beispiel 1

Ein L-Polylactid mit einer inhärenten Viskosität von 7 bis 9 dl/g (z.B. das Handelsprodukt Resomer® L 214 der Firma Boehringer KG) wurde als Probekörper mit den Abmessungen 30x10x2 mm an einem Synchrotron mit 2,3 GeV Elektronenenergie 13,5 min bei einem mittleren Ringstrom von 25 mA und einen Scannerhub von 10 mm durch eine Röntgenmaske mit Teststrukturen bildmäßig bestrahlt. Der Abtrag fand bei der nachfolgenden Entwicklung mit einer 1 %igen Lösung von Natriumhydroxid in 1:1 Wasser/Isopropanol bei 25°C/30 min statt. Die Abtragstiefe betrug 350 µm. Das strukturierte L-Polylactid ist an typischen "Kerbspannungs"-Teststrukturen völlig frei von Spannungsrissen. Feinstrukturen der Testmaske, wie 5 µm breite Gräben, Mikrozahnräder, Mikrospiralen, Stege mit 25 µm Breite, und Säulen mit 25 µm Durchmesser sind frei von singulären und statistischen Fehlstellen.

### Vergleichsbeispiel 1

Ein Probekörper aus PMMA wurde unter den entsprechenden Bedingungen 13,5 min bestrahlt und mit dem für PMMA optimierten Entwickler (GG-Entwickler) strukturiert. Der Abtrag betrug nur 80 µm. Bei den "Kerbspannungs"-Teststrukturen, an den Mikrozahnradkränzen und bei den Mikrospiralen treten Spannungsrisse auf. Weitere Mikrostrukturen der Testmaske, wie 5 µm breite Gräben, Stege mit 25 µm Breite, und Säulen mit 25 µm Durchmesser sind frei von singulären und statistischen Fehlstellen.

### Beispiel 2

Ein L-Polylactid mit einer inhärenten Viskosität von 2,9 dl/g (z.B. das Handelsprodukt Resomer® LR 909 der Firma Boehringer KG) wurde als Probekörper mit den Abmessungen 30x10x2 mm an einem Synchrotron mit 2,3 GeV Elektronenenergie 13,5 min bei einem mittleren Ringstrom von 25 mA und einen Scannerhub von 10 mm durch eine Röntgenmaske mit Teststrukturen bildmäßig bestrahlt. Der Abtrag fand bei der nachfolgenden Entwicklung mit einer 1 %igen Lösung von Natriumhydroxid in 1:1 Wasser/Isopropanol bei 25°C/30 min statt. Die Abtragstiefe betrug 380 µm. Das strukturierte L-Polylactid ist an typischen "Kerbspannungs"-Teststrukturen völlig frei von Spannungsrissen. Mikrostrukturen der Testmaske, wie 5 µm breite Gräben, Zahnräder, Spiralen, Stege mit 25 µm Breite, und Säulen mit 25 µm Durchmesser sind frei von singulären und statistischen Fehlstellen.

### Vergleichsbeispiel 2

Ein Probekörper aus PMMA wurde unter den entsprechenden Bedingungen 13,5 min bestrahlt. Der Abtrag betrug nur 80 µm (Entwicklung mit GG-Entwickler). Bei den "Kerbspannungs"-Teststrukturen, an den Mikrozahnradkränzen und bei den Mikrospiralen treten Spannungsrisse auf. Weitere Mikrostrukturen der Testmaske, wie 5 µm breite Gräben, Stege mit 25 µm Breite, und Säulen mit 25 µm Durchmesser sind frei von singulären und statistischen Fehlstellen.

### Beispiel 3

Ein L-Polylactid, wie es in Beispiel 1 verwendet wurde, wurde als Probekörper mit den Abmessungen 30x10x2 mm an einem Synchrotron mit 2,3 GeV Elektronenenergie 22,5 min bei einem mittleren Ringstrom von 25 mA und einen Scannerhub von 10 mm durch eine Röntgenmaske mit Teststrukturen bildmäßig bestrahlt. Der Abtrag fand bei der nachfolgenden Entwicklung mit einer 1 %igen Lösung von Natriumhydroxid in 1:1 Wasser/Isopropanol bei 25°C/30 min statt. Die Abtragstiefe betrug 475 µm. Das strukturierte L-Polylactid ist an typischen "Kerbspannungs"-Teststrukturen völlig frei von Spannungsrissen. Feinstrukturen der Testmaske, wie 10 µm breite Gräben, Mikrozahnräder, Mikrospiralen, Stege mit 25 µm Breite, und Säulen mit 25 µm Durchmesser sind frei von singulären und statistischen Fehlstellen.

### Vergleichsbeispiel 3

Ein Probekörper aus PMMA wurde unter den entsprechenden Bedingungen 22,5 min bestrahlt. Der Abtrag betrug nur 150 µm (Entwicklung mit GG-Entwickler). Bei den "Kerbspannungs"-Teststrukturen, an den Mikrozahnradkränzen und bei den Mikrospiralen treten Spannungsrisse auf. Weitere Mikrostrukturen der Testmaske, wie 10 µm breite Gräben, Stege mit 25 µm Breite, und Säulen mit 25 µm Durchmesser sind frei von singulären und statistischen Fehlstellen.

### Beispiel 4

Ein L-Polylactid wie es in Beispiel 2 verwendet wurde, wurde als Probekörper mit den Abmessungen 30x10x2 mm an einem Synchrotron mit 2,3 GeV Elektronenenergie 22,5 min bei einem mittleren Ringstrom von 25 mA und einen Scannerhub von 10 mm durch eine Röntgenmaske mit Teststrukturen bildmäßig bestrahlt. Der Abtrag fand bei der nachfolgenden Entwicklung mit einer 1 %igen Lösung von Natriumhydroxid in 1:1 Wasser/Isopropanol bei 25°C/30 min statt. Die Abtragstiefe betrug 500 µm. Das strukturierte L-Polylactid ist an typischen "Kerbspannungs"-Teststrukturen völlig frei von Spannungsrissen. Mikrostrukturen der Testmaske, wie 10 µm breite Gräben, Mikrozahnräder, Mikrospiralen, Stege mit 25 µm Breite, und Säulen mit 25 µm Durchmesser sind frei von singulären und statistischen Fehlstellen.

### Vergleichsbeispiel 4

Ein Probekörper aus PMMA wurde unter den entsprechenden Bedingungen 22,5 min bestrahlt. Der Abtrag betrug nur 150 µm (Entwicklung mit GG-Entwickler). Bei den "Kerbspannungs"-Teststrukturen, an den Mikrozahnradkränzen und bei den Mikrospiralen treten Spannungsrisse auf. Weitere Mikrostrukturen der Testmaske, wie 10 µm breite Gräben, Stege mit 25 µm Breite, und Säulen mit 25 µm Durchmesser sind frei von singulären und statistischen Fehlstellen.

### Beispiel 5

Ein L-Polylactid einer inhärenten Viskosität von 7 bis 9 dl/g (Granulat; z.B. das Handelsprodukt Resomer® L 214 der Firma Boehringer KG) wurde durch Erhitzen auf 200°C/2 min in einem 30x80 mm Metallrahmen durch Pressen (250 kg/cm²) auf eine Kupferträgerplatte mit 200 nm Oberflächenrauhigkeit aufgebracht. Die Schichtdicke betrug 120 µm.

An einem Synchrotron mit 2,3 GeV Elektronenenergie wurde 13,5 min bei einem mittleren Ringstrom von 25 mA und einen Scannerhub von 10 mm durch eine Röntgenmaske mit Teststrukturen bildmäßig bestrahlt. Der Abtrag fand bei der nachfolgenden Entwicklung mit einer 1 %igen Lösung von Natriumhydroxid in 1:1 Wasser/Isopropanol bei 25°C/30 min statt. Der Abtrag betrug 120 µm, d.h. die elektrisch leitfähige Trägerplatte war freigelegt. Das strukturierte L-Polylactid ist an typischen "Kerbspannungs"-Teststrukturen völlig frei von Spannungsrissen. Feinstrukturen der Testmaske, wie 5 µm breite Gräben, Mikrozahnräder, Mikrospiralen, Stege mit 40 µm Breite, und Säulen mit 25 µm Durchmesser sind frei von singulären und statistischen Fehlstellen.

### Vergleichsbeispiel 5

PMMA kann auf einer Kupferplatte nicht entsprechend strukturiert werden, weil der GG-Entwickler das Kupfer komplexiert und anlöst.

### Beispiel 6

Ein L-Polylactid einer inhärenten Viskosität von 7 bis 9 dl/g (Granulat; z.B. das Handelsprodukt Resomer® L 214 der Firma Boehringer KG) wurde durch Erhitzen auf 200°C/2 min in einem 30x80 mm Metallrahmen durch Pressen (250 kg/cm²) auf eine Kupferträgerplatte mit einer Titanschicht von ca. 3 µm, welche oberflächlich oxidiert war, aufgebracht. Die Oberflächenrauhigkeit der Kupferplatte betrug ca. 200 nm. Die Resistschichtdicke betrug 350 µm.

An einem Synchrotron mit 2,3 GeV Elektronenenergie wurde 37,8 min bei einem mittleren Ringstrom von 25 mA und einen Scannerhub von 28 mm durch eine Röntgenmaske mit Teststrukturen bildmäßig bestrahlt. Der Abtrag fand bei der nachfolgenden Entwicklung mit einer 1 %igen Lösung von Natriumhydroxid in 1:1 Wasser/Isopropanol bei 25°C/30 min statt. Der Abtrag betrug 350 µm, d.h. die elektrisch leitfähige Trägerplatte war freigelegt. Das strukturierte L-Polylactid ist an typischen "Kerbspannungs"-Teststrukturen völlig frei von Spannungsrissen. Feinstrukturen der Testmaske, wie 5 µm breite Gräben, Mikrozahnräder, Mikrospiralen, Stege mit 25 µm Breite, und Säulen mit 40 µm Durchmesser sind frei von singulären und statistischen Fehlstellen. Das strukturierte Laminat kann für galvanische Abscheidung von Metallen nach dem LIGA-Verfahren verwendet werden.

### Vergleichsbeispiel 6

Ein Laminat aus PMMA (350 µm) und dem in Beispiel 6 beschriebenen Träger wurde mit den entsprechenden Bedingungen 37,8 min bestrahlt. Der Abtrag betrug nur 90 µm (Entwicklung mit GG-Entwickler). Die elektrisch leitfähige Trägerplatte war nicht freigelegt. Das strukturierte Laminat kann deshalb für galvanische Abscheidungen von Metallen nach dem LIGA-Verfahren nicht verwendet werden.

## Patentansprüche

1. Verfahren zur Herstellung von Mikrostrukturkörpern mit Strukturtiefen von mehreren µm bis in den mm-Bereich durch bildmäßiges Bestrahlen von Polymeren mit Röntgenstrahlen, dadurch gekennzeichnet, daß als Polymere aliphatische Polyester eingesetzt werden.

2. Verfahren nach Anspruch 1, dadurch gekennzeichnet, daß als aliphatische Polyester Polyglycolid, Polylactid oder Glycolid-/Lactidcopolymere eingesetzt werden.

3. Verfahren nach Anspruch 1 oder 2, dadurch gekennzeichnet, daß als Röntgenstrahlen Synchrotronstrahlung eingesetzt wird.

4. Verfahren nach einem der vorhergehenden Ansprüche, dadurch gekennzeichnet, daß der aliphatische Polyester durch Spritzguß, Extrusion, Gießen und/oder Pressen auf einen Träger aufgebracht wird.

5. Verfahren nach einem der vorhergehenden Ansprüche, dadurch gekennzeichnet, daß Mikrostrukturkörper mit Strukturtiefen zwischen 3 µm und 2000 µm hergestellt werden.

6. Verfahren nach einem der vorhergehenden Ansprüche, dadurch gekennzeichnet, daß Mikrostrukturkörper mit Abtragstiefen von 10 µm bis 2000 µm und lateralen Abmessungen von unter 10 µm durch Bestrahlung mit Synchrotronstrahlung und Einwirkung selektiver Entwickler hergestellt werden.

7. Verfahren nach Anspruch 6, dadurch gekennzeichnet, daß als selektive Entwickler wäßrige oder alkoholische Natriumhydroxidlösungen oder Amin enthaltende Entwicklerlösungen eingesetzt werden.

## Claims

1. A process for producing microstructure elements having structure depths of from several µm to the mm region by imagewise irradiation of polymers with X-rays, wherein the polymers employed are aliphatic polyesters.

2. A process as claimed in claim 1, wherein the aliphatic polyesters employed are polyglycolide, polylactide or glycolide/lactide copolymers.

3. A process as claimed in claim 1 or 2, wherein the X-rays employed are in the form of synchrotron radiation.

4. A process as claimed in any one of the preceding claims, wherein the aliphatic polyesters are applied to a substrate by injection molding, extrusion, casting and/or compression molding.

5. A process as claimed in any one of the preceding claims, wherein microstructure elements having structure depths of from 3 µm to 2000 µm are produced.

6. A process as claimed in any one of the preceding claims, wherein microstructure elements having structure depths of from 10 µm to 2000 µm and lateral dimensions of less than 10 µm are produced by irradiation with synchrotron radiation and treatment with selective developers.

7. A process as claimed in claim 6, wherein the selective developers employed are aqueous or alcoholic sodium hydroxide solutions or amine-containing developer solutions.

## Revendications

1. Procédé de fabrication d'articles à microstructure à profondeurs de structure de plusieurs µm jusque dans la plage des mm, par exposition en conformité d'image de polymères à des rayons X, caractérisé en ce que l'on utilise des polyesters aliphatiques à titre de polymères.

2. Procédé suivant la revendication 1, caractérisé en ce que l'on utilise le polyglycolide, le polylactide ou des copolymères de glycolide/lactide à titre de polyesters aliphatiques.

3. Procédé suivant la revendication 1 ou 2, caractérisé en ce que l'on utilise un rayonnement synchrotrone à titre de rayons X.

4. Procédé suivant l'une quelconque des revendications précédentes, caractérisé en ce que l'on applique les polyesters aliphatiques sur un support par projection ou pulvérisation, extrusion, coulée et/ou compression.

5. Procédé suivant l'une quelconque des revendications précédentes, caractérisé en ce que l'on fabrique des articles à microstructure avec des profondeurs de structure comprises entre 3 µm et 2000 µm.

6. Procédé suivant l'une quelconque des revendications précédentes, caractérisé en ce que l'on fabrique des articles à microstructure avec des profondeurs de dépouillement de 10 µm à 2000 µm et des dimensions latérales inférieures à 10 µm par exposition au rayonnement synchrotrone et action de développateurs sélectifs.

7. Procédé suivant la revendication 6, caractérisé en ce qu'à titre de développateurs sélectifs, on utilise des solutions aqueuses ou alcooliques d'hydroxyde de sodium ou des solutions de développateur contenant une amine.
